(19)

Europäisches
Patentamt
European
Patent Office
Office européen
des brevets

(11) **EP 2 740 765 A1**

(12) **EUROPEAN PATENT APPLICATION**
published in accordance with Art. 153(4) EPC

(43) Date of publication:
**11.06.2014 Bulletin 2014/24**

(21) Application number: **12820076.3**

(22) Date of filing: **13.07.2012**

(51) Int Cl.:
*C08L 63/00* (2006.01)   *C08K 7/00* (2006.01)
*C08K 7/18* (2006.01)   *H01L 23/29* (2006.01)
*H01L 23/31* (2006.01)

(86) International application number:
**PCT/JP2012/067886**

(87) International publication number:
**WO 2013/018525 (07.02.2013 Gazette 2013/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.08.2011   JP 2011171051**

(71) Applicant: **Hitachi, Ltd.**
**Tokyo 100-8280 (JP)**

(72) Inventors:
• **MOTEKI Ryo**
**Hitachi-shi**
**Ibaraki 319-1292 (JP)**

• **KAGAWA Hiroyuki**
**Hitachi-shi**
**Ibaraki 319-1292 (JP)**
• **KOBAYASHI Masato**
**Hitachi-shi**
**Ibaraki 316-8501 (JP)**

(74) Representative: **Beetz & Partner**
**Patentanwälte**
**Steinsdorfstraße 10**
**80538 München (DE)**

(54) **EPOXY RESIN COMPOSITION FOR CAST MOLDING AND ELECTRICAL DEVICE USING SAME**

(57)    Provided is an epoxy resin composition for cast molding having excellent thermal conductivity and fluidity. This epoxy resin composition for cast molding contains an epoxy resin having two or more epoxy groups per molecule and being liquid at room temperature; an epoxy-resin-curing agent being liquid at room temperature; and inorganic fillers including a plate-like inorganic filler and a spherical inorganic filler. The plate-like inorganic filler and the spherical inorganic filler have two or more maxima in a particle size distribution of the entire inorganic fillers. The inorganic fillers include the plate-like inorganic filler in a content of from 5 to 20 percent by mass based on the total mass of the plate-like inorganic filler and the spherical inorganic filler.

*FIG. 1*

EP 2 740 765 A1

**Description**

Technical Field

The present invention relates to an epoxy resin composition for cast molding, which has excellent thermal conductivity and fluidity.

Background Art

Epoxy resins have excellent electrical insulating properties and are used as electrical insulating materials for electrical devices such as vacuum circuit breakers, vacuum switchgears, molded transformers, molded coils, and semiconductor devices. The electrical devices tend to produce heat in larger and larger quantities, and such increase in heat production may probably accelerate deterioration of the insulating materials or cause malfunction of the electrical devices. To prevent this, epoxy resin compositions for use as electrical insulating materials for the electrical devices should have high thermal conductivity. To allow epoxy resin compositions to have higher thermal conductivity, there is a technique of forming a thermal conducting path using granular and flat alumina as fillers, as described in Patent Literature (PTL) 1.

Exemplary techniques for forming electrical devices using an epoxy resin composition as an electrical insulating material include pressure cast molding and vacuum cast molding. The cast molding is a technique of placing a component of an electrical device in a mold, heating them, and casting a heated epoxy resin composition into the mold. The epoxy resin composition therefore required excellent fluidity. An exemplary technique for allowing the epoxy resin composition to have better fluidity is a technique of regulating the particle size distribution of the filler, as described in PTL 2.

Citation List

Patent Literature

PTL 1: Japanese Unexamined Patent Application Publication (JP-A) No. 2005-232313
PTL 2: JP-A No. 2005-290076

Summary of Invention

Technical Problem

However, the technique disclosed in PTL 1 hardly provides an epoxy resin composition for cast molding because PTL 1 fails to disclose the particle size distributions of the fillers and the ratio of the flat filler to the granular filler when the fillers are used in a resin for cast molding. The technique of regulating the particle size distribution of spherical alumina as described in PTL 2 disadvantageously suffers from insufficient improvement in thermal conductivity.

An object of the present invention is to provide an epoxy resin composition for cast molding which has excellent thermal conductivity and fluidity.

Solution to Problem

After intensive investigations to achieve the object, the present invention has been made and provides an epoxy resin composition as follows. This epoxy resin composition includes an epoxy resin having two or more epoxy groups per molecule and being liquid at room temperature; an epoxy-resin-curing agent being liquid at room temperature; and inorganic fillers including a plate-like inorganic filler and a spherical inorganic filler, where the inorganic fillers have two or more maxima in an entire particle size distribution;

in which the inorganic fillers include the plate-like inorganic filler in a content of from 5 to 20 percent by mass based on the total mass of the plate-like inorganic filler and the spherical inorganic filler.

Advantageous Effects of Invention

The present invention allows an epoxy resin composition to have better thermal conductivity and excellent fluidity. This can provide an epoxy resin composition for cast molding which has excellent thermal conductivity and fluidity.

In addition, it is verified that the present invention has a novel effect of suppressing the sedimentation and aggregation of fillers in the epoxy resin composition for cast molding.

Brief Description of Drawings

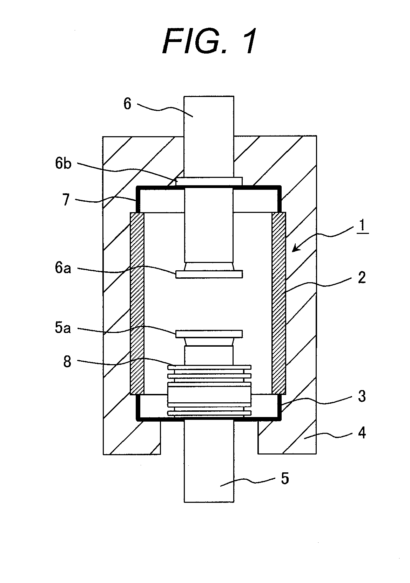

Figure 1 is a cross-sectional view illustrating the structure of a vacuum interrupter as molded according to the present invention.

Description of Embodiments

Preferred embodiments of the present invention will be illustrated as follows. It should be noted, however, that these embodiments are never construed to limit the scope of the present invention.

In a preferred embodiment, the epoxy resin composition includes an epoxy resin having two or more epoxy groups per molecule and being liquid at room temperature; an epoxy-resin-curing agent being liquid at room temperature; a plate-like inorganic filler; and a spherical inorganic filler, where the inorganic fillers have two or more maxima in the particle size distribution,
in which the maxima in the inorganic filler particle size distribution fall within the range of from 1 to 50 $\mu$m.

In another preferred embodiment, the epoxy resin composition includes an epoxy resin having two or more epoxy groups per molecule and being liquid at room temperature; an epoxy-resin-curing agent being liquid at room temperature; a plate-like inorganic filler; and a spherical inorganic filler, where the inorganic fillers have two or more maxima in the particle size distribution,
in which the ratio of the actual packing fraction to the close packing fraction of the inorganic fillers falls within the range of from 0.4 to 0.7.

The plate-like filler preferably has the ratio of its length (major axis) to breadth (minor axis) of from 1.5 to 10. As used herein the term "breadth" is distinguished from the "thickness" of the plate-like filler.

The epoxy resin for use in the present invention has two or more epoxy groups per molecule, is liquid at room temperature (20°C to 30°C), and is not limited in molecular weight and molecular structure. Such epoxy resins are exemplified by bisphenol-A epoxy resins, bisphenol-F epoxy resins, bisphenol-A/F epoxy resins, and alicyclic epoxy resins. Each of different epoxy resins may be used alone or in combination.

The epoxy resin composition for cast molding according to the present invention preferably has a viscosity of from 3 to 10 Pa·s. The epoxy resin composition preferably has a sedimentation rate of the inorganic fillers of 6% or less. The epoxy resin composition for cast molding according to the present invention preferably includes the plate-like inorganic filler in a content of from 20 to 26 percent by volume, and the spherical inorganic filler in a content of from 74 to 80 percent by volume based on the total mass of the inorganic fillers. The epoxy resin composition for cast molding according to the present invention preferably gives a cured article having a thermal conductivity of from 1.4 to 1.8 W/m·K.

The curing agent for use in the present invention is an epoxy-resin-curing agent that is liquid at room temperature (20°C to 30°C). Epoxy-resin-curing agents of this type are exemplified by acid anhydrides, aliphatic polyamines, aromatic polyamines, and alicyclic polyamines. Among them, acid anhydrides are preferred because they exhibit excellent workability upon cast molding and give cured articles having excellent properties. The acid anhydrides are exemplified by phthalic anhydride, hexahydrophthalic anhydride, and methylhexahydrophthalic anhydride. Though not critical, the epoxy resin and the curing agent may be generally used in a blending ratio in terms of equivalence ratio of around 1:1.

A curing accelerator for use in the present invention is exemplified by imidazoles such as 2-methylimidazole, 2-ethyl-4-methylimidazole, and 1-cyanoethyl-2-methylimidazole; and tertiary amines such as benzyldimethylamine and N-benzyldimethylamine. Each of different curing accelerators may be used alone or in combination. The curing accelerators may be generally added in an amount of from 0.1 to 10 percent by mass relative to the total mass of the epoxy resin and the curing agent, though the amount may be suitably selected according to the gel time and working life as an epoxy resin composition.

The plate-like inorganic filler for use in the present invention is exemplified by alumina, boron nitride, and aluminum nitride, of which alumina is preferred for excellent thermal conductivity and fluidity.

The spherical inorganic filler for use in the present invention is exemplified by alumina, silica, boron nitride, aluminum nitride, silicon carbide, and silicon nitride, of which alumina is preferred for excellent thermal conductivity and fluidity.

The plate-like inorganic filler for use in the present invention may have a ratio of length (major axis) to thickness of from 10 to 100. The spherical inorganic filler for use in the present invention may have a ratio of major axis to minor axis of from 1 to 10, preferably from 1 to 5, and particularly preferably from 1 to 1.3.

Where necessary, the epoxy resin composition according to the present invention may further include various additives suitably added. Such additives are exemplified by silane coupling agents such as epoxysilanes, aminosilanes, alkoxysilanes, and vinylsilanes; titanate coupling agents; aluminate coupling agents; colorants such as red iron oxide; stress-lowering components such as silicone rubbers; and antioxidants.

Electrical devices to which the epoxy resin composition for cast molding according to the present invention is applicable are exemplified by vacuum circuit breakers, vacuum switchgears, molded transformers, molded coils, and semiconductor devices. Figure 1 is a cross-sectional view of a vacuum interrupter which is molded using the epoxy resin composition for cast molding according to the present invention. A ceramic insulating cylinder 2, a fixed-side end plate 7, and a movable-side end plate 3 constitute a vacuum chamber 1. A fixed-electrode lead 6 having a fixed electrode 6a is mounted through a flange 6a to the vacuum chamber; whereas a movable-electrode lead 5 having a movable electrode 5a is mounted hermetically through bellows 8 to the vacuum chamber. A resin is cast, molded, and cured to form a solid insulating layer 4 around outside of the vacuum chamber. The vacuum interrupter often further includes an electroconductive layer (not shown) around the solid insulating layer 4, which electroconductive layer is grounded to ensure safety of the vacuum interrupter.

Embodiments of epoxy resin compositions according to this embodiment and electrical devices using them will be specifically illustrated below.

Measurement of Filler Particle Size Distribution

The filler particle size distribution was measured with the laser diffraction particle size distribution measuring apparatus MICROTRAC Model FRA (supplied by Nikkiso Co., Ltd.) in a measurement range of from 0.12 to 704 $\mu$m. The measurement was performed after mixing 0.5 gram of a sample filler with 100 ml of a 0.2 percent by weight sodium hexametaphosphate aqueous solution and ultrasonically dispersing the filler in the solution for about one minute. The particle size distribution is a plot of particle sizes and particle frequencies. A maximum in the particle size distribution refers to a particle size at which the particle frequency is highest. The maximum corresponds to an average particle size of the filler.

Calculation of Close Packing Fraction

The close packing fraction of the inorganic fillers was calculated according to an expression as follows:

Inorganic filler close packing fraction=1-[Void fraction]

The void fraction was calculated from the particle size distribution measurement result using the frequency at each particle size by the procedure described in Reference 1.

Reference 1: N. Ouchiyama and T. Tanaka, Ind. Eng. Chem. Fundam., 23, 490(1981)

Calculation of Actual Packing Fraction

The actual packing fraction of the total of the spherical inorganic filler and the plate-like inorganic filler as inorganic fillers was calculated according to Expressions 1 to 4 below. As used herein the term "resin component" refers to the epoxy resin, the epoxy-resin-curing agent, the curing accelerator, and the coupling agent. It was assumed that the resin component has a density of 1.1 g/cm$^3$. It was also assumed that the inorganic fillers have a density of 4.0 g/cm$^3$ because alumina fillers were used as the inorganic fillers.

[Math. 1]

```
Inorganic filler packing fraction=[Mass of inorganic

filler as packed]/[Mass of epoxy resin composition]

Expression 1


        Resin component volume=[1-(Inorganic filler packing

fraction)]/[Resin component density]        Expression 2


        Inorganic filler volume=Inorganic filler packing

fraction]/[Inorganic filler density]        Expression 3
```

$$\text{Inorganic filler actual packing fraction} = \text{[Inorganic filler packing fraction]}/\text{[(Resin component volume)+(Inorganic filler volume)]} \qquad \text{Expression 4}$$

Preparation of Epoxy Resin Component

To 100 parts by mass of a bisphenol-A epoxy resin (trade name JER828 supplied by Japan Epoxy Resins Co., Ltd.) was added alumina filler in a mass as given in Table 1, and they were mixed and stirred for about 30 minutes using a versatile mixer (supplied by Dalton Co., Ltd.) controlled at about 90°C while debubbling in a vacuum (10 Pa), and yielded an epoxy resin component.

Preparation of Curing Agent Component

To 88 parts by mass of an acid anhydride curing agent, i.e., methylhexahydrophthalic anhydride (trade name HN-5500 supplied by Hitachi Chemical Company, Ltd.) were added 0.3 part by mass of a curing accelerator, i.e., 1-(2-cyanoethyl)-2-ethyl-4-methylimidazole (trade name 2EAMZ-CN supplied by SHIKOKU CHEMICALS CORPORATION), 3 parts by mass of a coupling agent, i.e., $\gamma$-glycidoxypropyltrimethoxysilane (KBM403 supplied by Shin-Etsu Chemical Co., Ltd.), and an alumina filler in a mass given in Table 1. These components were mixed using the versatile mixer as used in the epoxy resin component and yielded a curable resin composition.
[Table 1]

TABLE 1

| Actual packing fraction of alumina fillers in cured article of epoxy resin composition (volume percent) | 29 | 50 | 56 |
|---|---|---|---|
| Epoxy resin component (part by weight) | 138 | 335 | 430 |
| Curing agent component (part by weight) | 148 | 345 | 440 |

In Table 1, the actual packing fractions (mass percent) of the alumina fillers in the cured articles derived from the epoxy resin compositions are 60%, 78%, and 82% in the left, middle, and right samples, respectively.

Heating/curing of Epoxy Resin Composition

The epoxy resin component and the curing agent component were weighed in different polypropylene containers and heated in a thermostat at 80°C for one hour. The heated epoxy resin component and curing agent component were mixed with each other in a mass ratio of 1:1. The resulting mixture was blended with stirring for about 10 minutes using a versatile mixer controlled at about 80°C while debubbling the mixture in a vacuum (10 Pa) and yielded an epoxy resin composition.
The prepared epoxy resin composition was poured into a test tube having an inner diameter of 15 mm, cured by heating at 85°C for 8 hours, and further cured by heating at 130°C for 12 hours. The inside of the test tube had been treated with Mould Release QZ-13 (supplied by Nagase ChemteX Corporation) so as to help the heated/cured epoxy resin composition to be retrieved easily from the test tube.
The epoxy resin composition retrieved from the test tube was cut to a thickness of 1 mm using the constant-feed-rate saw ISOMET LOWSPEED LOW (supplied by BUEHLER), and the cut epoxy resin composition was subjected to measurements necessary for the calculation of thermal conductivity.

Viscosity Measurement

An epoxy resin composition used in the viscosity measurement was prepared in the following manner. Initially, the epoxy resin component and the curing agent component were mixed with each other in a mass ratio of 1:1, blended in a versatile mixer at room temperature for 10 minutes, and yielded a single component as the epoxy resin composition. The viscosity of the epoxy resin composition was measured using the cone-plate viscometer Rheo Stress RS100 (supplied by HAAKE) at a cone-plate temperature of 60°C.

Thermal Conductivity Calculation

The thermal conductivity of the cured article was determined as a value at 25°C according to an expression as follows:

$$\text{Thermal conductivity=[Specific heat]}\times\text{[Specific gravity]}\times\text{[Thermal diffusivity]}$$

The specific heat was determined by measuring a heat flux according to Japanese Industrial Standard (JIS) K 7123 using the differential scanning calorimeter DSC Q2000 (supplied by TA Instruments), followed by calculation.
The specific gravity was measured with the electronic densimeter SD-2002 (supplied by Alfa Mirage Co., Ltd.).
The thermal diffusivity was determined by performing a measurement with the Xenon Light Flash Apparatus LFA477 (supplied by NETZSCH-Geratebau GmbH), followed by calculation according to the improved Cape-Lehman Model with pluse correction.

Evaluation of Filler Sedimentation Tendency

The filler sedimentation tendency was evaluated on the curing agent component in which filler sedimentation readily occurs. Initially, constituents of the curing agent component were mixed using a versatile mixer, weighed in a sample vial (35 in diameter, 110 ml) up to a height (distance from the vial bottom to the liquid level) of 80 mm, and left stand at 40°C for 30 days. After left stand for 30 days, a metal straightedge (scale) was inserted into the sample vial, and the height of the filler sedimentation was measured. The filler sedimentation tendency was calculated as a sedimentation rate by dividing the filler sedimentation height by 80, and multiplying the resulting value by 100.

Evaluation of Filler Aggregation Tendency

The filler cohesiveness was evaluated by observing the metal straightedge which had been retrieved from the sample vial after the filler sedimentation evaluation, and determining whether or not the filler aggregated.

Molding of Vacuum interrupter for Vacuum Circuit Breaker

The epoxy resin component and the curing agent component were each weighed and heated in a 60°C thermostat for one hour. After one hour, the epoxy resin component and the curing agent component were mixed with each other in a mass ratio of 1:1 and debubbled at 60°C in a vacuum for one hour. Separately, a vacuum interrupter was placed in a mold and heated at 85°C for one hour. The cast vacuum interrupter molding was performed through pressure cast molding, and the resin composition was cured at 85°C for 8 hours and subsequently at 130°C for 12 hours.

Evaluation of Epoxy Resin Composition Filling Ability

The filling ability of the epoxy resin composition was evaluated by molding the vacuum interrupter and determining whether or not an unfilled part was present in the mold through X-ray computed tomography (CT). As used herein the term "unfilled part" refers to a void (cavity) present in the mold.

Alumina Fillers

The alumina fillers used in Examples or Comparative Examples herein are as follows.

Spherical alumina filler: DMA-07 (supplied by DENKI KAGAKU KOGYO KABUSHIKI KAISHA, having an average particle size of 7 $\mu$m)
Spherical alumina filler: DMA-45 (supplied by DENKI KAGAKU KOGYO KABUSHIKI KAISHA, having an average particle size of 45 $\mu$m)
Spherical alumina filler: DMA-70 (supplied by DENKI KAGAKU KOGYO KABUSHIKI KAISHA, having an average particle size of 70 $\mu$m)
Plate-like alumina filler: YFA 05025 (supplied by KINSEI MATEC CO., LTD., having an average particle size of 5 $\mu$m)
Plate-like alumina filler: YFA 00610 (supplied by KINSEI MATEC CO., LTD., having an average particle size of 0.6 $\mu$m)
Plate-like alumina filler: YFA 10030 (supplied by KINSEI MATEC CO., LTD., having an average particle size of 10 $\mu$m)

The alumina fillers used in Examples 1 and 3 included DMA-45, DAM-07, and YFA 05025 in a mass ratio of 8:1.5:0.5.

The alumina fillers used in Comparative Example 1 included DMA-45 and DAM-07 in a mass ratio of 8:2.

The alumina fillers used in Comparative Example 3 included DMA-45, DAM-07, and YFA 10030 in a mass ratio of 8:1.9:0.1.

The evaluation results of Examples and Comparative Examples are indicated in Tables 2 and 3, respectively.

Examples 1 to 6

The resin compositions according to Examples 1 to 6 had low viscosities, and cured articles obtained therefrom had high thermal conductivity. This is because the mass percentage of the plate-like alumina filler in the fillers, the average particle size and the ratio of the actual packing fraction to the close packing fraction each of the used alumina fillers fell within the above-specified ranges. In addition, the resin compositions had low alumina filler sedimentation rates and were protected from alumina filler aggregation. Furthermore, the resin compositions did not cause a resin unfilled part (void) when used in vacuum interrupter molding. The resin compositions according to Examples had an alumina filler actual packing fraction of 50 percent by volume.

Comparative Examples 1 to 8

The resin composition according to Comparative Example 1 employed no plate-like alumina filler, thereby had a lower thermal conductivity than those of Examples 1 to 6, and had a higher alumina filler sedimentation rate than those of Examples 1 to 6.

The resin composition according to Comparative Example 2 employed a plate-like alumina filler, but in an excessively large amount, thereby had a higher viscosity than those of Examples 1 to 6, and suffered from alumina filler aggregation. The resin composition therefore caused a resin unfilled part when used in vacuum interrupter molding.

The resin composition according to Comparative Example 3 included a plate-like alumina filler in an excessively small amount, thereby had a lower thermal conductivity than those of Examples 1 to 6, and had a higher alumina filler sedimentation rate than those of Examples 1 to 6.

The resin composition according to Comparative Example 4 employed a plate-like alumina filler having an average particle size of 0.6 $\mu$m, smaller than 1.0 $\mu$m, thereby had a large surface area of the filler, and had a higher viscosity than those of Examples 2 and 5. The resin composition therefore caused a resin unfilled part when used in vacuum interrupter molding.

The resin composition according to Comparative Example 5 employed a spherical alumina filler having an average particle size of 70 $\mu$m, larger than 50 $\mu$m, thereby had a smaller surface area of the filler, and had a lower thermal conductivity than those of Examples 2 and 5.

The resin composition according to Comparative Example 6 had an alumina filler actual packing fraction of 0.56, thereby had a ratio of the actual packing fraction to the close packing fraction of the alumina filler of 0.75, and had a higher viscosity than that of Example 5. The resin composition therefore caused a resin unfilled part when used in vacuum interrupter molding.

The resin composition according to Comparative Example 7 had an alumina filler actual packing fraction of 0.29, thereby had a ratio of the actual packing fraction to the close packing fraction of the alumina filler of 0.35, and had a lower thermal conductivity than those of Examples 1 to 6.

The resin composition according to Comparative Example 8 employed a plate-like alumina filler and a spherical alumina filler with a small difference in average particle size between them, thereby had a low close packing fraction, had a ratio of the actual packing fraction to the close packing fraction of the alumina filler of 0.8, and had a higher viscosity than those of Examples 1 to 6. The resin composition therefore caused a resin unfilled part when used in vacuum interrupter molding.

The resin compositions according to Comparative Examples 1 to 5 and 8 each had an actual packing fraction of 50 percent by volume; the resin composition according to Comparative Example 6 had an actual packing fraction of 56 percent by volume; and the resin composition according to Comparative Example 7 had an actual packing fraction of 29 percent by volume.

[Table 2]

TABLE 2

| Item | Example 1 | Example 2 | Example 3 | Example 4 | Example 5 | Example 6 |
|---|---|---|---|---|---|---|
| Ratio of plate-like alumina filler in fillers (mass percent) | 5 | 10 | 20 | 5 | 10 | 20 |

(continued)

| Item | Example 1 | Example 2 | Example 3 | Example 4 | Example 5 | Example 6 |
|---|---|---|---|---|---|---|
| Average particle size of plate-like alumina filler ($\mu$m) | 5 | 5 | 5 | 10 | 10 | 10 |
| Average particle size of spherical alumina filler ($\mu$m) | 45 7 | 45 | 45 | 45 7 | 45 | 45 |
| Actual packing fraction of alumina fillers | 0.5 | 0.5 | 0.5 | 0.5 | 0.5 | 0.5 |
| Ratio of actual packing fraction to close packing fraction of alumina fillers | 0.6 | 0.59 | 0.62 | 0.6 | 0.59 | 0.62 |
| Thermal conductivity (W/m·K) | 1.4 | 1.6 | 1.7 | 1.4 | 1.6 | 1.7 |
| Viscosity (Pa·s) | 6.2 | 6.2 | 10 | 4.3 | 5.2 | 9.0 |
| Alumina filler sedimentation rate (%) | 5.0 | 4.7 | 4.5 | 5.1 | 4.8 | 4.7 |
| Alumina filler aggregation | absent | absent | absent | absent | absent | absent |
| Unfilled part formed in vacuum interrupter molding | absent | absent | absent | absent | absent | absent |

[Table 3]

TABLE 3

| Item | Com. Ex. 1 | Com. Ex. 2 | Com. Ex. 3 | Com. Ex. 4 | Com. Ex. 5 | Com. Ex. 6 | Com. Ex. 7 | Com. Ex. 8 |
|---|---|---|---|---|---|---|---|---|
| Ratio of plate-like alumina filler in fillers (mass percent) | 0 | 30 | 1 | 10 | 10 | 10 | 10 | 10 |
| Average particle size of plate-like alumina filler ($\mu$m) | 0 | 10 | 10 | 0.6 | 10 | 10 | 10 | 5 |
| Average particle size of spherical alumina filler ($\mu$m) | 45 7 | 45 | 45 7 | 45 | 70 | 40 | 40 | 7 |
| Actual packing fraction of alumina fillers | 0.5 | 0.5 | 0.5 | 0.5 | 0.5 | 0.56 | 0.29 | 0.5 |
| Ratio of actual packing fraction to close packing fraction of alumina fillers | 0.61 | 0.58 | 0.6 | 0.68 | 0.65 | 0.75 | 0.38 | 0.8 |
| Thermal conductivity (W/m·K) | 1.2 | 1.9 | 1.3 | 1.8 | 1.2 | 1.8 | 1.2 | 1.6 |
| Viscosity (Pa·s) | 5.2 | 40 | 6.0 | 31 | 5.3 | 45 | 3 | 50 |
| Alumina filler sedimentation rate (%) | 6.5 | 3.2 | 6 | 2.1 | 5.2 | 3.2 | 4.2 | 3.9 |
| Alumina filler aggregation | absent | present | absent | absent | absent | absent | absent | absent |
| Unfilled part formed in vacuum interrupter molding | absent | present | absent | present | absent | present | absent | present |

Reference Signs List

1	vacuum chamber
2	insulating cylinder
3	movable-side end plate
4	solid insulating layer
5	movable-electrode lead
5a	movable electrode
6	fixed-electrode lead
6a	fixed electrode
6b	flange
7	fixed-side end plate
8	bellows

## Claims

1. An epoxy resin composition for cast molding, comprising:

   an epoxy resin having two or more epoxy groups per molecule and being liquid at room temperature;
   an epoxy-resin-curing agent being liquid at room temperature; and
   inorganic fillers comprising:

      a plate-like inorganic filler; and
      a spherical inorganic filler,

   wherein:
   the plate-like inorganic filler and the spherical inorganic filler have two or more maxima in a particle size distribution of the entire inorganic fillers; and the inorganic fillers comprise the plate-like inorganic filler in a content of from 5 to 20 percent by mass based on the total mass of the plate-like inorganic filler and the spherical inorganic filler.

2. The epoxy resin composition for cast molding according to claim 1, having a viscosity of from 3 to 10 Pa·s.

3. The epoxy resin composition for cast molding according to claim 1, having a sedimentation rate of the inorganic fillers of 6% or less.

4. The epoxy resin composition for cast molding according to claim 1, wherein the maxima in the particle size distribution of the plate-like inorganic filler and the spherical inorganic filler fall within a range of from 1 to 50 $\mu$m.

5. The epoxy resin composition for cast molding according to any one of claims 1 to 4,
   wherein the plate-like inorganic filler and the spherical inorganic filler have a ratio of actual packing fraction to close packing fraction of from 0.4 to 0.7.

6. The epoxy resin composition for cast molding according to any one of claims 1 to 5, wherein the plate-like inorganic filler has a particle size of from 1 to 30 $\mu$m; and the spherical inorganic filler has a particle size of from 1 to 100 $\mu$m.

7. The epoxy resin composition for cast molding according to any one of claims 1 to 6, wherein the inorganic fillers comprise 20 to 26 percent by volume of the plate-like inorganic filler; and 74 to 80 percent by volume of the spherical inorganic filler based on the total mass of the inorganic fillers.

8. An epoxy resin cured article derived from the epoxy resin composition for cast molding of any one of claims 1 to 7, wherein the cured article has a thermal conductivity of from 1.4 to 1.8 W/m·K.

9. An electrical device obtained through cast molding with the epoxy resin composition for cast molding of any one of claims 1 to 7.

# FIG. 1

| INTERNATIONAL SEARCH REPORT | International application No. |
|---|---|
| | PCT/JP2012/067886 |

A. CLASSIFICATION OF SUBJECT MATTER
*C08L63/00*(2006.01)i, *C08K7/00*(2006.01)i, *C08K7/18*(2006.01)i, *H01L23/29*
(2006.01)i, *H01L23/31*(2006.01)i

According to International Patent Classification (IPC) or to both national classification and IPC

B. FIELDS SEARCHED

Minimum documentation searched (classification system followed by classification symbols)
C08L63/00, C08K7/00, C08K7/18, H01L23/29, H01L23/31

Documentation searched other than minimum documentation to the extent that such documents are included in the fields searched
    Jitsuyo Shinan Koho        1922-1996   Jitsuyo Shinan Toroku Koho   1996-2012
    Kokai Jitsuyo Shinan Koho  1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-232313 A (Mitsubishi Electric Corp.), 02 September 2005 (02.09.2005), claims 1, 3; paragraphs [0001], [0035]; fig. 1 & US 2006/0188727 A1 | 1-9 |
| A | JP 2005-290076 A (Sumitomo Bakelite Co., Ltd.), 20 October 2005 (20.10.2005), claim 1; paragraphs [0006], [0013] (Family: none) | 1-9 |
| A | JP 2011-57734 A (Hitachi Electric Systems Co., Ltd.), 24 March 2011 (24.03.2011), claims 1, 7 to 9; paragraphs [0001], [0054] to [0056], [0086] (Family: none) | 1-9 |

| ☒ Further documents are listed in the continuation of Box C. | ☐ See patent family annex. |
|---|---|

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 27 July, 2012 (27.07.12) | 07 August, 2012 (07.08.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## INTERNATIONAL SEARCH REPORT

| International application No. |
| --- |
| PCT/JP2012/067886 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2005-162787 A  (Sumitomo Bakelite Co., Ltd.), 23 June 2005 (23.06.2005), claim 1; paragraphs [0009], [0042], [0044], [0104] (Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005232313 A

- JP 2005290076 A

**Non-patent literature cited in the description**

- **N. OUCHIYAMA ; T. TANAKA.** *Ind. Eng. Chem. Fundam.,* 1981, vol. 23, 490